(19) Europäisches Patentamt
European Patent Office
Office européen des brevets

(11) **EP 3 830 873 B1**

(12) **FASCICULE DE BREVET EUROPEEN**

(45) Date de publication et mention de la délivrance du brevet:
**22.06.2022 Bulletin 2022/25**

(21) Numéro de dépôt: **19761922.4**

(22) Date de dépôt: **26.07.2019**

(51) Classification Internationale des Brevets (IPC):
***H01L 27/146*** *(2006.01)*

(52) Classification Coopérative des Brevets (CPC):
**H01L 27/1462; H01L 27/14625; H01L 27/14665**

(86) Numéro de dépôt international:
**PCT/FR2019/051855**

(87) Numéro de publication internationale:
**WO 2020/021211 (30.01.2020 Gazette 2020/05)**

(54) **DISPOSITIF DE DETECTION DE RAYONNEMENT ELECTROMAGNETIQUE**

VORRICHTUNG ZUR ERKENNUNG VON ELEKTROMAGNETISCHER STRAHLUNG

DEVICE FOR DETECTING ELECTROMAGNETIC RADIATION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **27.07.2018 FR 1857039**

(43) Date de publication de la demande:
**09.06.2021 Bulletin 2021/23**

(73) Titulaire: **LYNRED**
**91120 Palaiseau (FR)**

(72) Inventeur: **PERE-LAPERNE, Nicolas**
**38000 Grenoble (FR)**

(74) Mandataire: **Talbot, Alexandre**
**Cabinet Hecké**
**28 Cours Jean Jaurès**
**38000 Grenoble (FR)**

(56) Documents cités:
**WO-A1-2015/004235      WO-A1-2015/115229**
**US-A- 5 365 088**

## Description

### Domaine technique de l'invention

L'invention est relative à un dispositif de détection de rayonnement électromagnétique. Le document WO 2015/115229 A1 décrit un dispositif de détection.

### État de la technique

De manière à détecter un ou plusieurs signaux électromagnétiques dans une scène, il est courant d'utiliser un dispositif de détection. Le dispositif de détection comporte une pluralité de couches empilées les unes sur les autres afin de réaliser les fonctions optiques et électro-optiques nécessaires à la détection du signal observé.

Le dispositif de détection comporte des couches électriquement conductrices, des couches électriquement isolantes et/ou des couches semi-conductrices assemblées de manière à capter le rayonnement électromagnétique et diriger les charges électriques formées dans le dispositif de détection vers les bornes de sortie afin que le signal électrique soit traité.

Le dispositif de détection comporte encore des empilements de couches qui sont configurés pour éliminer au moins une partie des signaux optiques parasites qui sont généralement des filtres optiques bloquant le rayonnement électromagnétique hors de la gamme de longueur d'onde d'intérêt. En plus de la fonctionnalité de filtre, il est courant d'avoir une ou plusieurs lentilles qui concentrent le rayonnement électromagnétique vers les zones de transformation du rayonnement électromagnétique en un signal électrique.

Les empilements utilisés pour former les dispositifs de détection sont complexes de sorte qu'un important travail de simulation est réalisé avant de fabriquer et tester ces produits.

Pour détecter le rayonnement électromagnétique, il est courant d'utiliser des dispositifs de détection refroidis, c'est-à-dire l'association d'un dispositif de détection avec un refroidisseur afin que le dispositif de détection fonctionne à basse température. Le refroidisseur permet de refroidir le dispositif de détection de manière à réduire certaines composantes de bruit.

Il apparait que lors de la réalisation pratique du dispositif de détection simulé, les performances obtenues ne sont pas toujours en accords avec les résultats des simulations ce qui nécessite des étapes longues et couteuses de développement complémentaires.

### Objet de l'invention

Un objet de l'invention consiste à remédier à ces inconvénients, et à réaliser un dispositif de détection qui est plus performant que les dispositifs de détection de l'art antérieur et notamment à basse température.

Il est particulièrement avantageux de prévoir un dispositif de détection comportant :

- un premier empilement absorbant configuré pour absorber un rayonnement électromagnétique dans au moins une première gamme de longueur d'onde et présentant un premier coefficient de dilatation thermique et
- un deuxième empilement formant une fonction optique et présentant un deuxième coefficient de dilatation thermique.

Le dispositif de détection est remarquable en ce que le premier coefficient de dilatation thermique est différent du deuxième coefficient de dilatation thermique et en ce qu'il comporte une couche tampon séparant le premier empilement et le deuxième empilement, la couche tampon présentant une épaisseur comprise entre $0,5\mu m$ et $50\mu m$ de manière à absorber les contraintes mécaniques introduites par le premier empilement.

Dans un développement, la couche tampon est électriquement isolante.

Dans un mode de réalisation particulier, la couche tampon est configurée pour ne pas absorber la première gamme de longueur d'onde.

Il est avantageux de prévoir un dispositif de détection dans lequel :

- le premier empilement absorbant comporte un premier photodétecteur et un deuxième photodétecteur adjacent au premier photodétecteur,
- le deuxième empilement comporte un premier filtre faisant face au premier photodétecteur, le premier filtre étant configuré pour laisser passer une première gamme de longueur d'onde et pour bloquer une deuxième gamme de longueur d'onde différente de la première gamme de longueur d'onde, le deuxième photodétecteur est recouvert par une fonction optique différente du premier filtre de manière à dissocier le rayonnement électromagnétique reçu par les premier et deuxième photodétecteurs.

Dans une alternative de réalisation, la fonction optique est une couche antireflet qui recouvre également le premier photodétecteur.

Il est avantageux de prévoir que la fonction optique soit un deuxième filtre configuré pour laisser passer la deuxième gamme de longueur d'onde et pour bloquer la première gamme de longueur d'onde.

Dans un autre développement, le premier photodétecteur et le deuxième photodétecteur sont configurés pour absorber la première gamme de longueur d'onde et la deuxième gamme de longueur d'onde.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :

- la figure 1 illustre de façon schématique, en coupe, un mode de réalisation d'un dispositif de détection,
- les figures 2 à 4 représentent, de manière schématique, en coupe, des étapes de réalisation d'un procédé de fabrication d'un dispositif de détection,
- les figures 5 et 6 représentent, de manière schématique, en coupe, des étapes de réalisation d'un autre procédé de fabrication d'un dispositif de détection.

**Description détaillée**

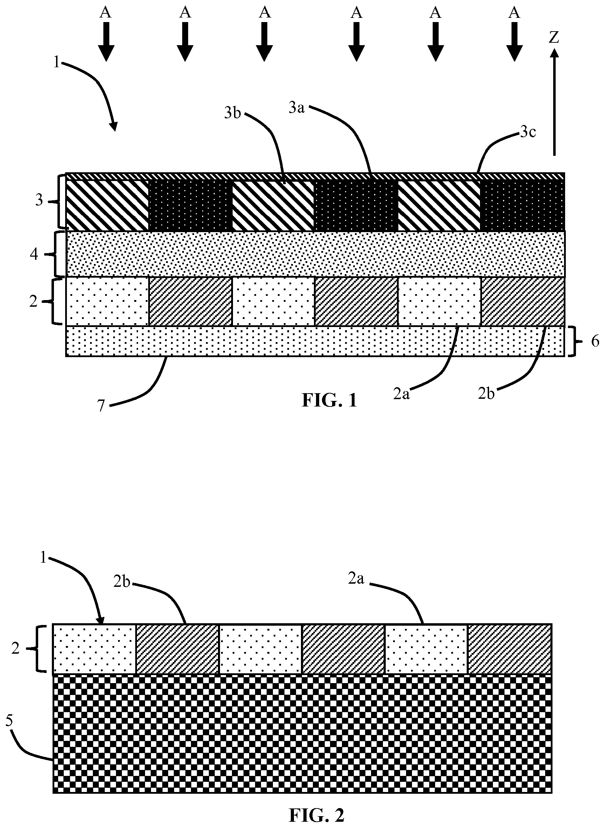

Comme illustré à la figure 1, le dispositif de détection 1 comporte un premier empilement absorbant 2 qui est formé par une ou plusieurs couches électriquement conductrices et semi-conductrices qui sont agencées de manière à capter un rayonnement électromagnétique A dans au moins une première gamme de longueur d'onde et avantageusement dans au moins une première gamme de longueur d'onde et une deuxième gamme de longueur d'onde différente de la première gamme de longueur d'onde. La première gamme de longueur d'onde n'a pas de recouvrement avec la deuxième gamme de longueur d'onde.

Le premier empilement 2 comporte avantageusement une couche absorbante également appelé matériau absorbant qui est configuré pour absorber le rayonnement incident et le transformer en des porteurs de charge électrique formant un signal électrique. Les porteurs de charge électrique provenant de l'absorption d'un rayonnement lumineux sont également appelés photoporteurs. Le matériau absorbant peut être un matériau II-VI ou un matériau III-V. Le matériau absorbant peut être choisi parmi HgCdTe, InSb, InAsSb, InGaAs et InP. Par matériau III-V, on entend un matériau semiconducteur composés d'un ou plusieurs éléments de la colonne III (bore, gallium, aluminium, indium, etc.) et de la colonne V (arsenic, antimoine, phosphore, etc.) du tableau périodique de Mendeleïev. Par matériau II-VI, on entend un matériau semiconducteur composés d'un ou plusieurs éléments de la colonne II (zinc, cadmium, mercure, etc.) et de la colonne VI (soufre, sélénium, Tellure, etc.) du tableau périodique de Mendeleïev.

Une première face du premier empilement 2 est recouverte au moins partiellement, c'est-à-dire partiellement ou totalement recouverte par un deuxième empilement 3 formant une fonction optique. Selon les modes de réalisation, la fonction optique peut être un antireflet, un filtre ou une lentille. Il est également possible de prévoir que le deuxième empilement 3 réalise plus d'une fonction parmi les fonctions décrites plus haut, par exemple un filtre associé à un anti-reflet ou une lentille associée à un anti-reflet. Il est encore possible de prévoir que le deuxième empilement 3 réalise ces trois fonctions. Selon les configurations, le filtre peut être un filtre passehaut, un filtre passebas ou un filtre passe-bande.

Une couche anti-reflet est une couche configurée pour laisser passer au moins 99% du rayonnement lumineux incident sur toute la gamme de longueur d'onde d'étude, par exemple dans toute la gamme de longueur d'onde absorbée par le photodétecteur ou dans toute la gamme de longueur d'onde passant à travers le filtre associé.

La fonction anti-reflet peut être réalisée par une seule couche ou par plusieurs couches préférentiellement en matériau électriquement isolant également appelé diélectrique. Lorsque la fonction anti-reflet est formée par une seul couche, il est avantageux de réaliser la fonction anti-reflet par une couche dont l'épaisseur d est définie par $d = \lambda/4n$, avec n l'indice optique de la couche anti-reflet et $\lambda$ la longueur d'onde caractéristique de la gamme de longueur d'onde pour laquelle la fonction anti-reflet est recherchée. La longueur d'onde caractéristique est avantageusement la longueur d'onde moyenne de la gamme de longueur d'onde, mais il est possible de se décaler de cette valeur moyenne à l'intérieur de la gamme de longueur d'onde d'intérêt. La fonction antireflet n'est pas configurée pour changer la forme du faisceau lumineux incident entre son entrée et sa sortie.

Une lentille est une fonction optique qui est configurée pour laisser passer au moins 99% du rayonnement lumineux incident sur toute la gamme de longueur d'onde d'étude et pour mettre en forme le rayonnement incident. Ainsi, la forme du rayonnement incident est différente entre l'entrée de la lentille et la sortie de la lentille.

Un filtre est une fonction optique configurée pour laisser passer une gamme de longueur d'onde et bloquer une autre gamme de longueur. Par exemple, le filtre est configuré pour laisser passer la première gamme de longueur d'onde et bloquer la deuxième gamme de longueur d'onde. Le filtre est avantageusement configuré pour laisser passer au moins 90% de la première gamme de longueur d'onde et pour bloquer au moins 90% de la deuxième gamme de longueur ou inversement.

Le premier empilement absorbant 2 est séparé du deuxième empilement 3 formant une fonction optique par une couche tampon 4. La couche tampon 4 est configurée pour absorber les contraintes thermomécaniques qui existent entre le premier empilement 2 et le deuxième empilement 3.

Les inventeurs ont observé que le premier empilement 2 absorbant présente un premier coefficient de dilatation thermique qui est différent du deuxième coefficient de dilatation thermique présent dans le deuxième empilement 3 formant la fonction optique. Lorsque le premier empilement 2 est en contact direct avec le deuxième empilement 3, cette différence de coefficient de dilatation thermique entraine l'apparition d'un jeu de contraintes dans le premier empilement absorbant 2 et ce jeu de contraintes modifie le comportement électro-optique du premier empilement 2. Il est donc avantageux de séparer le premier empilement 2 et le deuxième empilement 3 pour réduire voire éliminer les contraintes du deuxième empilement 3 sur le premier empilement 2.

Par coefficient de dilatation thermique, on entend un coefficient de dilatation thermique moyen sur une gamme de température qui s'étend entre une première température et une deuxième température. La première température correspond par exemple à la température de fonctionnement du dispositif de détection lorsque ce dernier capte un signal électromagnétique et le transfert sous la forme d'un signal électronique à un circuit de traitement. La première température est par exemple comprise entre 20°C et 30°C. De manière avantageuse, la première température est inférieure à 0°C et préférentiellement inférieure à 200K et encore plus avantageusement comprise entre 80K et 200K. La deuxième température peut correspondre à la température de dépôt d'une ou plusieurs couches formant la fonction optique 3. La température de dépôt peut être supérieure à 50°C. Par exemple, la deuxième température est égale à 80°C.

En absorbant les contraintes mécaniques générées par le deuxième empilement 3 formant la fonction optique, la couche tampon 4 permet de rapprocher le premier empilement 2 de son fonctionnement attendu, c'est-à-dire de son fonctionnement sans les contraintes mécaniques de la fonction optique ou avec des contraintes plus homogènes voire identiques entre les photodétecteurs formés dans l'empilement absorbante.

La couche tampon 4 peut être formée par une couche ou par plusieurs couches différentes, c'est-à-dire formée par des matériaux différents. Il est particulièrement avantageux de prévoir que la couche tampon 4 soit réalisée par une seule couche car cela permet de diminuer les perturbations optiques entre le deuxième empilement 3 formant la fonction optique et le premier empilement 2 absorbant le rayonnement étudié. A chaque fois que le signal optique rencontre une interface, une partie du signal optique est diffractée et est perdue.

De manière avantageuse, la couche tampon 4 est homogène. Elle présente avantageusement une composition identique de la face en contact avec la couche absorbante 2 jusqu'à la face en contact avec le deuxième empilement 3. De préférence cette homogénéité de composition est présente selon une ou plusieurs directions parallèles au plan d'interface entre la couche absorbante et la couche tampon et éventuellement perpendiculairement à l'interface entre la couche tampon 4 et la couche absorbante 2. Par composition identique, on entend avantageusement que le dopage est constant d'une face à l'autre et/ou selon une ou plusieurs directions parallèles au plan d'interface entre la couche absorbante 2 et la couche tampon 4.

La couche tampon 4 est configurée de manière à ne pas procurer de fonction optique et notamment aucune des fonctions optiques listées ci-dessus. La couche tampon 4 est configurée pour ne pas absorber le rayonnement électromagnétique d'intérêt, c'est-à-dire le rayonnement électromagnétique qui doit être absorbé par le premier empilement 2. La couche tampon 4 est configurée pour présenter un taux d'absorption du rayonnement étudié inférieur à 20%, c'est-à-dire que le premier empilement 2 reçoit entre 100% et 80% du rayonnement transmis par le deuxième empilement 3. De cette manière, la couche tampon 4 est la plus neutre optiquement pour le fonctionnement du dispositif de détection. Avantageusement, la couche tampon 4 est configurée pour présenter un taux d'absorption du rayonnement étudié inférieur à 10% voire 5%.

La couche tampon 4 est configurée pour ne pas présenter de fonction électrique, c'est-à-dire qu'elle n'est pas configurée pour faire passer un courant électrique depuis le premier empilement 2 vers le deuxième empilement 3. La couche tampon 4 est également configurée pour ne pas faire passer un courant électrique transversalement, c'est-à-dire selon une direction parallèle à l'interface entre la couche tampon 4 et le premier empilement 2.

La couche tampon 4 peut être réalisée par une couche électriquement isolante. La couche tampon 4 peut être formée partiellement ou complètement par un matériau diélectrique, c'est-à-dire par un matériau électriquement isolant. Il est également possible de prévoir que la couche tampon 4 soit formée partiellement ou complètement par un matériau polymère. La couche tampon 4 peut également être formée partiellement ou complètement par un matériau semi-conducteur non dopé ou faiblement dopé de manière à empêcher le passage d'un courant électrique. Si un matériau semi-conducteur est utilisé, il n'absorbe pas le rayonnement électromagnétique recherché.

Dans certains modes de réalisation, la couche tampon 4 peut être formée par une couche qui présente un dopage en dopants électriquement actifs supérieur à $1.10^{16}$cm$^{-3}$. Cependant, la couche tampon 4 n'est pas configurée pour réaliser une fonction de génération et collection de photo-porteurs dans la gamme spectrale d'intérêt. Ce dopage peut être un dopage non volontaire, c'est-à-dire que la couche est non intentionnellement dopée.

Dans un mode de réalisation avantageux, la couche tampon 4 est réalisée dans un matériau amorphe. Dans un autre mode de réalisation, la couche tampon 4 est réalisée en accord de paramètre de maille avec le matériau absorbant 2 afin de ne pas introduire ou de limiter l'apparition d'une contrainte liée à un désaccord de paramètre de maille avec le matériau absorbant 2.

La couche tampon 4 présente une épaisseur totale qui est comprise entre $0{,}5\mu$m et $50\mu$m. Cette gamme d'épaisseur est particulièrement avantageuse car elle permet d'accommoder les contraintes technologiques d'un deuxième empilement 3 comportant par exemple une pluralité de lentilles et/ou une pluralité de filtres. Les lentilles permettent de faire converger une quantité importante du signal optique observé vers un photodétecteur de section plus faible.

L'épaisseur de la couche tampon 4 est inférieure à un seuil au-delà duquel la cavité optique qui existe entre le premier empilement 2 et le deuxième empilement 3 est soumise à des problèmes de diaphonie entre deux pixels adjacents c'est-à-dire entre deux photodétecteurs immédiatement adjacents. Les inventeurs ont observé qu'au-delà d'une épaisseur de 50μm, il est très difficile de réaliser une cavité optique qui est dépourvue des problèmes de diaphonie.

Par exemple, pour un dispositif de détection comportant une pluralité de pixels arrangés avec un pas de répétition égal à 15μm, des simulations optiques géométriques montrent que l'introduction d'une couche tampon 4 supérieure à 50μm exacerbe la diaphonie optique ce qui réduit fortement les performances du dispositif. Par exemple, dans cet exemple, l'utilisation d'une couche tampon 4 dont l'épaisseur est inférieure ou égale à 40μm permet de conserver un dispositif de détection avec des performances en diaphonie acceptables.

Par exemple, pour un dispositif de détection dont les pixels sont arrangés avec un pas de répétition égal à 15μm, il est avantageux d'utiliser une couche tampon 4 dont l'épaisseur est inférieure ou égale à 26μm pour avoir des performances quasi-optimales.

De manière avantageuse, pour limiter la diaphonie, lorsque le dispositif de détection présente une pluralité de photodétecteurs dans la couche absorbante 2 avec un pas de répétition P, il est avantageux d'utiliser une couche tampon 4 dont l'épaisseur d est inférieure à P/(2*tan(1/2n)) avec n l'indice optique de la couche tampon 4, c'est-à-dire

$$d \leq \frac{P}{2*\tan\left(\frac{1}{2n}\right)}.$$

Les inventeurs ont observé que l'intégration d'une fonction optique hétérogène impose également de décaler l'empilement absorbant au delà d'une valeur minimale. Une fonction optique hétérogène peut être formée par une pluralité de lentilles et/ou une pluralité de filtres dans le deuxième empilement 3, c'est-à-dire par la présence d'au moins deux empilements différents 3a et 3b selon une direction perpendiculaire à l'interface entre la couche tampon 4 et le deuxième empilement 3. Les deux empilements différents 3a et 3b sont adjacents selon une direction parallèle à l'interface entre le premier empilement 2 et la couche tampon 4.

Comme les deux empilements sont différents, ils peuvent induire des contraintes mécaniques différentes dans la couche absorbante 2.

Dans un mode de réalisation avantageux, la couche tampon 4 est formée par un matériau semi-conducteur qui est en accord de paramètre de maille avec le premier empilement 2 ou sensiblement en accord de paramètre de maille avec le premier empilement 2. Par sensiblement en accord de paramètre de maille, on entend que la différence de paramètre de maille est inférieure à 1% entre la couche tampon 4 et le premier empilement 2.

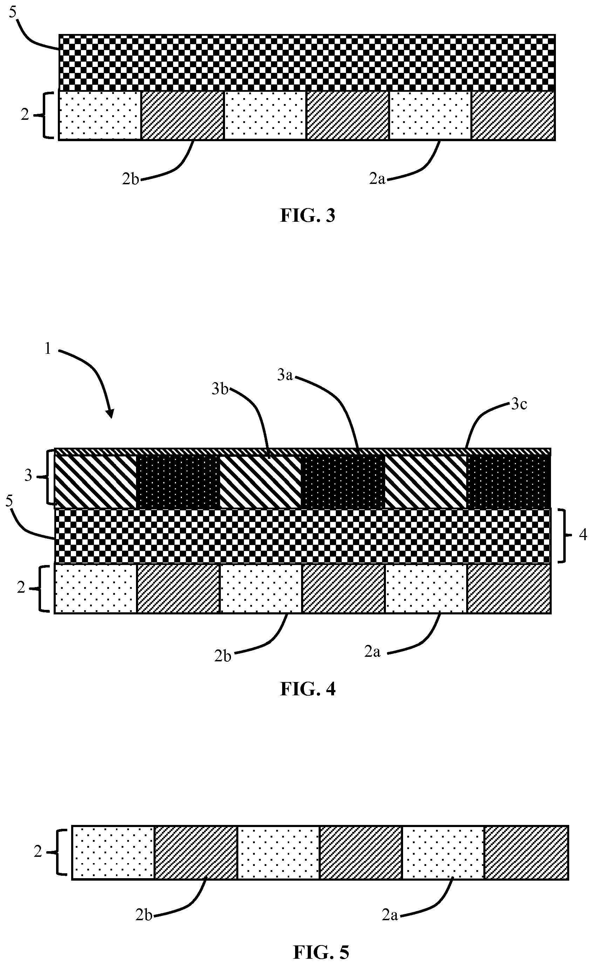

Dans un mode de réalisation particulier illustré aux figures 2, 3 et 4, le premier empilement 2 est réalisé sur une première face d'un substrat initial 5, par exemple le premier empilement 2 est réalisé par épitaxie (figure 2). Les différentes couches du premier empilement 2 sont formées sur la première face 5a. Ensuite, la deuxième face 5b opposée à la première face 5a est recouverte par le deuxième empilement 3. Le substrat 5 est conservé au moins partiellement afin d'absorber les contraintes. Très souvent, une étape d'amincissement du substrat initial 5 est réalisée avant de déposer le deuxième empilement 3 car l'épaisseur du substrat est très importante et entraine des perturbations optiques dans le dispositif de détection. L'amincissement du substrat 5 est illustré à la figure 3 avant l'étape de formation du deuxième empilement 3 (figure 4).

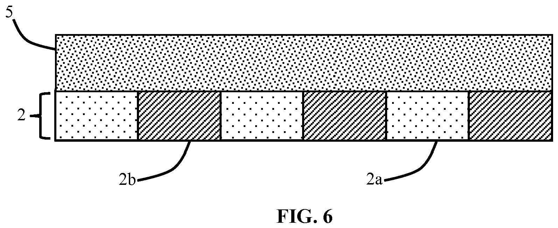

Dans un autre mode de réalisation particulier illustré par les figures 2, 5 et 6, le premier empilement 2 est réalisé sur une première face 5a d'un substrat initial 5 par exemple par épitaxie (figure 2). Les différentes couches du premier empilement 2 sont formées sur la première face 5a puis le substrat initial 5 est éliminé comme cela est illustré à la figure 5. La couche tampon 4 est déposée sur le premier empilement 2, sur la face initialement en contact avec le substrat 5 qui a été éliminé (figure 6) avant la formation du deuxième empilement 3.

Ensuite, le deuxième empilement 3 est déposé sur la couche tampon 4 de manière à ce que le premier empilement 2 et le deuxième empilement 3 soient séparés par la couche tampon 4. La figure 5 est schématique car les photodétecteurs sont très souvent associés à un substrat de support, par exemple les circuits de lecture 7 ou un support intermédiaire afin d'assurer la tenue mécanique des photodétecteurs 2a/2b lors de la formation de la fonction optique. Le circuit de lecture 7 est configuré pour réaliser la collection des photo-porteurs vers un circuit intégré de traitement du signal.

Dans un mode de réalisation particulier, le dispositif de détection est un dispositif de détection multispectrale dans lequel, le premier empilement 2 comporte au moins un premier photodétecteur 2a sensible à une première gamme de longueur d'onde également appelée première bande spectrale et un deuxième photodétecteur 2b sensible à une deuxième gamme de longueur d'onde également appelée deuxième bande spectrale.

Dans un mode de réalisation particulier, le premier photodétecteur 2a et le deuxième photodétecteur 2b comportent un seul film semi-conducteur qui est configuré pour absorber la première gamme de longueur d'onde et la deuxième gamme de longueur d'onde. Ce mode de réalisation est particulièrement avantageux car il est très compact et il permet de réaliser les deux photodétecteurs en même temps.

Dans un mode de réalisation avantageux, le dispositif de détection comporte une pluralité de premiers photodétecteurs 2a et de deuxièmes photodétecteurs 2b. La pluralité de premiers photodétecteurs 2a et la pluralité de deuxièmes photodétecteurs 2b forment un réseau plan focal, c'est-à-dire que tous les photodétecteurs sont réalisés dans un même plan.

De manière préférentielle, le premier empilement 2 comporte autant de premiers photodétecteurs 2a que de deuxièmes photodétecteurs 2b. En alternative, il est également possible de prévoir que le premier empilement 2 comporte un nombre de premiers photodétecteurs 2a qui est différent du nombre de deuxièmes photodétecteurs 2b.

Dans un mode de réalisation particulier, la deuxième gamme de longueur d'onde est différente de la première gamme de longueur d'onde. De manière avantageuse, la deuxième gamme de longueur d'onde est dissociée de la première gamme de longueur d'onde c'est-à-dire que les gammes de longueur d'onde ne se chevauchent pas. Selon les modes de réalisation, les première et deuxième gammes de longueur d'onde ont une borne commune ou elles sont séparées par une gamme de longueur d'onde.

Le premier photodétecteur 2a et le deuxième photodétecteur 2b sont tous les deux sensibles à la première gamme de longueur d'onde et à la deuxième gamme de longueurs d'ondes. En d'autres termes, le premier photodétecteur 2a et le deuxième photodétecteur 2b sont en mesure de capter le rayonnement émis dans la première gamme de longueur d'onde et de fournir un signal électrique représentatif de ce rayonnement. Le premier photodétecteur 2a et le deuxième photodétecteur 2b sont également en mesure de capter le rayonnement émis dans la deuxième gamme de longueur d'onde et de fournir un signal électrique représentatif de ce rayonnement.

De manière avantageuse, les première et deuxième gammes de longueur d'onde sont des gammes du rayonnement infrarouge. Dans un mode de réalisation particulier, la première gamme de longueur d'onde et la deuxième gamme de longueur d'onde sont choisies parmi les gammes suivantes :

MWIR : entre $3\mu m$ et $8\mu m$,
LWIR : entre $8\mu m$ et $15\mu m$,
SWIR : entre $1,4\mu m$ et $3\mu m$.

Il est donc possible de configurer le dispositif de détection afin que ce dernier puisse détecter différents couples de gammes de longueur d'onde, par exemple MWIR/LWIR, MWIR/SWIR ou LWIR/SWIR.

Il est encore possible découper les différentes gammes présentées ci-dessus en deux sous-gammes différentes. Dans un mode de réalisation particulier, les première et deuxième gammes de longueur d'onde divisent par exemple le rayonnement MWIR en deux sous-gammes distinctes. Il peut en être de même pour le LWIR et le SWIR.

Les conditions d'alimentation des photodétecteurs 2a et 2b peuvent être différentes. Avantageusement, les conditions d'alimentation sont identiques pour tous les photodétecteurs. Les conditions d'alimentation sont fournies par un premier circuit de lecture pour le premier photodétecteur 2a et par un deuxième circuit de lecture pour le deuxième photodétecteur 2b.

Les photodétecteurs 2a et 2b et les circuits de lecture 7a et 7b sont avantageusement disposés sur un support 6. Le support 6 présente un troisième coefficient de dilatation thermique qui peut être différent du premier coefficient de dilatation thermique et du deuxième coefficient de dilatation thermique. La couche tampon 4 est alors adaptée pour que l'ensemble formé par le support 6 et le premier empilement absorbant 2 soit moins perturbé ou ne soit pas perturbé par le deuxième empilement 3 formant une fonction optique.

Avantageusement, afin de spécialiser les premier et deuxième photodétecteurs 2a et 2b, le deuxième empilement 3 est configuré pour former un système de filtrage du rayonnement incident.

Dans une première configuration, le deuxième empilement 3 est configuré pour bloquer une partie du rayonnement incident à l'entrée du premier photodétecteur 2a et ne pas bloquer le rayonnement incident à l'entrée du deuxième photodétecteur 2b.

Par exemple, le deuxième empilement 3 comporte un premier filtre 3a qui est configuré pour laisser passer la première gamme de longueur d'onde et pour bloquer la deuxième gamme de longueur d'onde. Le premier filtre 3a peut être un filtre interférentiel ou un filtre à absorption.

Selon les modes de réalisation, la première gamme de longueur d'onde peut présenter des longueurs d'onde plus longues ou plus courtes que la deuxième gamme de longueur d'onde. Le premier filtre 3a peut donc être un filtre passe-bas ou un filtre passe-haut dont la longueur d'onde de coupure se trouve entre la première gamme de longueur d'onde et la deuxième gamme de longueur d'onde. En alternative, il est également possible de prévoir que le premier filtre 3a est un filtre passe-bande qui laisse passer la première gamme de longueur d'onde et qui bloque la deuxième gamme de longueur d'onde.

Le premier filtre 3a est un filtre qui est déposé directement sur la couche tampon 4, c'est-à-dire sur une partie du réseau plan focal. Le premier filtre 3a n'est pas formé au-dessus sur le deuxième photodétecteur 2b ainsi le premier filtre 3a vient recouvrir le premier photodétecteur 2a et il laisse découvert le deuxième photodétecteur 2b. Le premier filtre 3a est en contact mécanique avec le premier photodétecteur 2a par l'intermédiaire de la couche tampon 4.

Au moyen de cette configuration particulière, le premier photodétecteur 2a ne reçoit qu'une partie du rayonnement incident. Le premier photodétecteur 2a reçoit la première gamme de longueur d'onde et il ne reçoit pas la deuxième gamme de longueur d'onde. En revanche, le deuxième photodétecteur 2b reçoit la première gamme de longueur d'onde et la deuxième gamme de longueur d'onde car il n'est pas associé au premier filtre 3a.

Le premier photodétecteur 2a émet un signal électrique qui est représentatif du rayonnement reçu. Le signal électrique en provenance du premier photodétecteur 2a est représentatif du rayonnement dans la première gamme de longueur d'onde.

De manière avantageuse, le premier photodétecteur 2a est connecté à un circuit de lecture 7 qui stocke le signal émis par le photodétecteur associé. Le circuit de lecture 7 transmet un autre premier signal électrique qui est avantageusement un signal en tension à un circuit de traitement (non représenté). Le deuxième photodétecteur 2b est également connecté au circuit de traitement qui reçoit un deuxième signal électrique.

Dans un mode de réalisation particulier, une couche anti-reflet 3c est formée dans le deuxième empilement 3. Dans un mode de réalisation, la couche anti-reflet 3c est disposée entre le premier filtre 3a et la couche tampon 4. En alternative, la couche anti-reflet 3c est disposée au-dessus du premier filtre 3a de sorte que le premier filtre 3a sépare la couche anti-reflet 3c et le premier empilement 2.

Il est particulièrement avantageux de prévoir que le deuxième photodétecteur 2b soit recouvert par une fonction optique différente du premier filtre 3a. Cette fonction optique est avantageusement choisie parmi les fonctions optiques présentées plus haut, par exemple un autre filtre.

De manière préférentielle, la fonction optique additionnelle disposée au dessus du deuxième photodétecteur 2b est constituée par ou comporte une couche anti-reflet. Dans cette configuration, le deuxième empilement 3 est hétérogène avec des empilements de couches différents au-dessus du premier photodétecteur 2a et du deuxième photodétecteur 2b. Les empilements étant différents, les coefficients de dilatation thermique sont également différents et/ou les contraintes résiduelles qui existent dans ces deux empilements sont différentes. Il y a alors introduction d'un jeu de contraintes qui varie spatialement d'une fonction optique à l'autre. L'absence de couche tampon 4 entraine des réponses différentes des premier et deuxième photodétecteurs 2a et 2b. Lors de la fabrication du dispositif de détection, le premier empilement 2 est plus sensible à l'alignement du deuxième empilement 3. En introduisant la couche tampon 4, il est possible de former des dispositifs de détection qui sont plus répétables et plus conformes au fonctionnement attendu.

Dans un autre mode de réalisation, le deuxième empilement 3 comporte deux fonctions optiques adjacentes qui sont différentes, par exemple un premier filtre 3a et un deuxième filtre 3b qui présentent des propriétés optiques différentes. Le deuxième filtre 3b est adjacent au premier filtre 3a selon une direction parallèle à l'interface entre le premier empilement 2 et la couche tampon 4. Le deuxième filtre 3b est configuré pour laisser passer la deuxième gamme de longueur d'onde et pour bloquer la première gamme de longueur d'onde. Le deuxième filtre 3b peut être un filtre interférentiel ou un filtre à absorption.

Pour fonctionnaliser les pixels, les filtres 3a et 3b sont différents ce qui induit des jeux de contraintes entre les photodétecteurs. Dans la mesure où les contraintes appliquées sur les détecteurs sont différentes cela peut induire des différences dans le vieillissement d'un photodétecteur par rapport au photodétecteur adjacent. Cela peut également induire une différence de réponse électrique. Le jeu de contraintes peut également générer des défauts cristallographiques qui dégradent le fonctionnement du dispositif de détection.

Des simulations ont montré que la différence de contraintes introduite par la différenciation des fonctions optiques au-dessus des photodétecteurs introduit un jeu de contraintes hétérogène et qui devient homogène à une profondeur environ égale à 400nm en partant de l'interface sur laquelle sont formés les filtres de différenciation des réponses optiques.

Il est donc particulièrement avantageux d'utiliser une couche tampon 4 dont l'épaisseur est au moins égale à 500nm afin que tous les photodétecteurs soient soumis au même jeu de contraintes et d'une manière plus générale que le matériau absorbant soit soumis à une contrainte homogène.

De manière particulièrement avantageuse, une couche tampon 4 ayant une épaisseur au moins égale à $2\mu m$ permet de fortement réduire voire éliminer la contrainte introduite par la fonction optique dans la couche absorbante 2. De cette manière, le fonctionnement des photodétecteurs est plus proche voire identique à ce qui est attendu lors des simulations ou des tests sans fonction optique.

De manière avantageuse, le dispositif de détection est un dispositif de détection refroidi, c'est-à-dire un dispositif qui est configuré pour fonctionner à une température inférieure à 200K. Par exemple, le dispositif de détection est configuré pour présenter une température de fonctionnement comprise entre 80K et 200K. Le dispositif de détection est avantageusement couplé à un système de refroidissement 7 qui permet de le refroidir à sa température de fonctionnement. Dans ces conditions, la différence de température qui existe entre la température de formation du deuxième empilement 3 et la température de fonctionnement est très importante ce qui peut induire des contraintes importantes.

## Revendications

1. Dispositif de détection (1) comportant :

   - un premier empilement absorbant (2) configuré pour absorber un rayonnement électromagnétique dans au moins une première gamme de longueur d'onde et présentant un premier coefficient de dilatation thermique, le premier empilement absorbant (2) comportant une couche en matériau absorbant et
   - un deuxième empilement (3) formant une fonction optique et présentant un deuxième coefficient de dilatation thermique,

   où le premier coefficient de dilatation thermique est différent du deuxième coefficient de dilatation thermique et le dispositif de détection comporte une couche tampon (4) séparant le premier empilement (2) et le deuxième empilement (3) de manière à séparer le premier empilement absorbant (2) d'un jeu de contraintes mécaniques introduit par le deuxième empilement (3), **caractérisé en ce que**

la couche tampon (4) présentant une épaisseur comprise
entre 0,5$\mu$m et 50$\mu$m,
**en ce que** la couche tampon (4) est formée par un matériau semi-conducteur qui est en accord de paramètre de maille avec le premier empilement (2) ou **en ce que** la différence de paramètre de maille entre la couche tampon (4) et le premier empilement (2) est inférieure à 1%, et **en ce que** le matériau absorbant est un matériau II-VI ou un matériau III-V.

2. Dispositif de détection (1) selon la revendication 1, dans lequel la couche tampon (4) est électriquement isolante.

3. Dispositif de détection (1) selon l'une des revendications 1 ou 2, dans lequel la couche tampon (4) est configurée pour ne pas absorber la première gamme de longueur d'onde.

4. Dispositif de détection (1) selon l'une quelconque des revendications 1 à 3, dans lequel :

- le premier empilement absorbant (2) comporte un premier photodétecteur (2a) et un deuxième photodétecteur (2b) adjacent au premier photodétecteur (2a),
- le deuxième empilement (3) comporte un premier filtre (3a) faisant face au premier photodétecteur (2a), le premier filtre (3a) étant configuré pour laisser passer une première gamme de longueur d'onde et pour bloquer une deuxième gamme de longueur d'onde différente de la première gamme de longueur d'onde, le deuxième photodétecteur (2a) est recouvert par une fonction optique différente du premier filtre (3a) de manière à dissocier le rayonnement électromagnétique reçu par les premier et deuxième photodétecteurs (2a, 2b).

5. Dispositif de détection (1) selon la revendication 4, dans lequel la fonction optique est une couche anti-reflet qui recouvre également le premier photodétecteur (2a).

6. Dispositif de détection (1) selon la revendication 4, dans lequel la fonction optique est un deuxième filtre (3b) faisant face au deuxième photodétecteur (2b) et configuré pour laisser passer la deuxième gamme de longueur d'onde et pour bloquer la première gamme de longueur d'onde.

7. Dispositif de détection (1) selon l'une quelconque des revendications 4 à 6, dans lequel le premier et le deuxième photodétecteurs (2a, 2b) sont configurés pour absorber la première gamme de longueur d'onde et la deuxième gamme de longueur d'onde.

8. Dispositif de détection (1) selon l'une quelconque des revendications précédentes, dans lequel le premier empilement absorbant (2) comporte une pluralité de photodétecteurs arrangés selon un pas de répétition P et dans lequel la couche tampon présente une épaisseur d telle que

$$d \leq \frac{P}{2*\tan\left(\frac{1}{2n}\right)}$$

avec n l'indice optique de la couche tampon (4).

**Patentansprüche**

1. Detektionsvorrichtung (1), umfassend:

- einen ersten absorbierenden Stapel (2), der dazu konfiguriert ist, eine elektromagnetische Strahlung in mindestens einem ersten Wellenlängenbereich zu absorbieren, und der einen ersten Wärmeausdehnungskoeffizienten aufweist, wobei der erste absorbierende Stapel (2) eine Schicht aus absorbierendem Material umfasst, und
- einen zweiten Stapel (3), der eine optische Funktion bildet und einen zweiten Wärmeausdehnungskoeffizienten aufweist, wobei der erste thermische Ausdehnungskoeffizient sich vom zweiten Wärmeausdehnungskoeffizienten unterscheidet und die Detektionsvorrichtung eine Pufferschicht (4) aufweist, die den ersten Stapel (2) und den zweiten Stapel (3) trennt, um den ersten absorbierenden Stapel (2) von einem mechanischen Spannungsspiel zu trennen, das durch den zweiten Stapel (3) eingebracht wird, **dadurch gekennzeichnet, dass** die Pufferschicht (4) eine Dicke zwischen 0,5 $\mu$m und 50 $\mu$m aufweist,

dadurch, dass die Pufferschicht (4) aus einem Halbleitermaterial gebildet ist, dessen Gitterkonstante mit dem ersten Stapel (2) übereinstimmt, oder dass die Differenz der Gitterkonstante zwischen der Pufferschicht (4) und dem ersten Stapel (2) kleiner als 1 % ist,
und dadurch, dass das absorbierende Material ein II-VI-Material oder ein III-V-Material ist.

2. Detektionsvorrichtung (1) nach Anspruch 1, wobei die Pufferschicht (4) elektrisch isolierend ist.

**3.** Detektionsvorrichtung (1) nach einem der Ansprüche 1 oder 2, wobei die Pufferschicht (4) dazu konfiguriert ist, den ersten Wellenlängenbereich nicht zu absorbieren.

**4.** Detektionsvorrichtung (1) nach einem der Ansprüche 1 bis 3, wobei:

- der erste absorbierende Stapel (2) einen ersten Fotodetektor (2a) und einen zweiten Fotodetektor (2b) benachbart zum ersten Fotodetektor (2a) umfasst,
- der zweite Stapel (3) einen ersten Filter (3a) umfasst, der dem ersten Fotodetektor (2a) gegenüberliegt, wobei der erste Filter (3a) dazu konfiguriert ist, einen ersten Wellenlängenbereich durchzulassen und einen zweiten Wellenlängenbereich, der sich vom ersten Wellenlängenbereich unterscheidet, zu blockieren, der zweite Fotodetektor (2a) mit einer optischen Funktion bedeckt ist, die sich vom ersten Filter (3a) unterscheidet, um die elektromagnetische Strahlung, die vom ersten und zweiten Fotodetektor (2a, 2b) empfangen wird, zu dissoziieren.

**5.** Detektionsvorrichtung (1) nach Anspruch 4, wobei die optische Funktion eine Antireflexionsschicht ist, die auch den ersten Fotodetektor (2a) bedeckt.

**6.** Detektionsvorrichtung (1) nach Anspruch 4, wobei die optische Funktion ein zweiter Filter (3b) ist, der dem zweiten Fotodetektor (2b) gegenüberliegt und dazu konfiguriert ist, den zweiten Wellenlängenbereich durchzulassen und den ersten Wellenlängenbereich zu blockieren.

**7.** Detektionsvorrichtung (1) nach einem der Ansprüche 4 bis 6, wobei der erste und der zweite Fotodetektor (2a, 2b) dazu konfiguriert sind, den ersten Wellenlängenbereich und den zweiten Wellenlängenbereich zu absorbieren.

**8.** Detektionsvorrichtung (1) nach einem der vorherigen Ansprüche, wobei der erste absorbierende Stapel (2) eine Vielzahl von Fotodetektoren aufweist, die in einem Wiederholungsabstand P angeordnet sind, und wobei die Pufferschicht eine derartige Dicke d aufweist, dass $d \leq \frac{P}{2*\tan\left(\frac{1}{2n}\right)}$ , wobei n der optische Index der Pufferschicht (4) ist.

## Claims

**1.** Detection device (1) comprising:

- an absorbent first stack (2) configured to absorb an electromagnetic radiation in at least a first wavelength range and presenting a first thermal expansion coefficient, the absorbent first stack (2) comprising a layer made from absorbent material and
- a second stack (3) forming an optical function and presenting a second thermal expansion coefficient,

where the first thermal expansion coefficient is different from the second thermal expansion coefficient and the detection device comprises a buffer layer (4) separating the absorbent first stack (2) and second stack (3) so as to separate the absorbent first stack (2) from a set of mechanical stresses introduced by the second stack (3),

**characterized in that** the buffer layer (4) presents a thickness comprised between $0.5\,\mu m$ and $50\,\mu m$, and **in that** the buffer layer (4) is formed by a semiconductor material that is lattice matched with the first stack (2) or **in that** the difference of lattice parameter between the buffer layer (4) and absorbent first stack (2) is less than 1%, and **in that** the absorbent material is a II-VI material or a III-V material.

**2.** Detection device (1) according to claim 1, wherein the buffer layer (4) is electrically insulating.

**3.** Detection device (1) according to one of claims 1 or 2, wherein the buffer layer (4) is configured not to absorb the first wavelength range.

**4.** Detection device (1) according to any one of claims 1 to 3, wherein:

- the absorbent first stack (2) comprises a first photodetector (2a) and a second photodetector (2b) adjacent to the first photodetector (2a),
- the second stack (3) comprises a first filter (3a) facing the first photodetector (2a), the first filter (3a) being configured to let a first wavelength range pass and to block a second wavelength range different from the first wavelength range, the second photodetector (2a) being covered by an optical function different from the first filter (3a) so as to dissociate the electromagnetic radiation received by the first and second photodetectors (2a, 2b).

**5.** Detection device (1) according to claim 4, wherein the optical function is an anti-reflective layer that also covers the first photodetector (2a).

**6.** Detection device (1) according to claim 4, wherein the optical function is a second filter (3b) facing the second photodetector (2b) and configured to let the second wavelength range pass and to block the first wavelength range.

7. Detection device (1) according to any one of claims 4 to 6, wherein the first and second photodetectors (2a, 2b) are configured to absorb the first wavelength range and the second wavelength range.

8. Detection device (1) according to any one of the foregoing claims, wherein the absorbent first stack (2) comprises a plurality of photodetectors arranged with a repetition pitch P and wherein the buffer layer

$$d \leq \frac{P}{2*\tan\left(\frac{1}{2n}\right)}$$

presents a thickness d such that with n the optical index of the buffer layer (4).

**FIG. 1**

**FIG. 2**

**FIG. 3**

**FIG. 4**

**FIG. 5**

**FIG. 6**

**EP 3 830 873 B1**

## RÉFÉRENCES CITÉES DANS LA DESCRIPTION

**Documents brevets cités dans la description**

- WO 2015115229 A1